# EUROPÄISCHE PATENTANMELDUNG

(11) **EP 3 457 156 A1**
(43) Veröffentlichungstag der Anmeldung: **20.03.2019**
(21) Anmeldenummer: 17191928.5
(22) Anmeldetag: 19.09.2017
(51) Int. Cl.: G01R 33/28, G01R 33/54

(54) **INTEGRIERTE STEUERVORRICHTUNG FÜR EINE MAGNETRESONANZEINRICHTUNG**

(71) Anmelder: Siemens Healthcare GmbH, 91052 Erlangen (DE)
(72) Erfinder: Campagna, Swen, 91238 Engelthal (DE)

(57) **Zusammenfassung**

Die Erfindung betrifft eine Steuervorrichtung (10) für eine Magnetresonanzeinrichtung (11), ein System (20), ein Steuersystem (30) und eine Magnetresonanzanlage (40).

Die erfindungsgemäße Steuervorrichtung (10) für eine Magnetresonanzeinrichtung (40) weist
- ein Steuermodul (12),
- ein Peripheriemodul (13),
- einen Empfangsmodulanschluss (15) und
- eine Hauptplatineneinheit (16) auf,
wobei das Steuermodul (12)
- eine zentrale Koordinationskomponente (12.1),
- eine Hochfrequenzsteuerkomponente (12.2) und
- eine Gradientenspulensteuerkomponente (12.3) aufweist,
- wobei das Steuermodul (12) und das Peripheriemodul (13) Echtzeitanforderungen erfüllen,
- wobei der Empfangsmodulanschluss (15) zu einem Anschließen eines Empfangsmoduls (17) ausgebildet ist,
- wobei das Steuermodul (12), das Peripheriemodul und der Empfangsmodulanschluss (15) in die Hauptplatineneinheit integriert sind.

## Beschreibung

Die Erfindung betrifft eine Steuervorrichtung für eine Magnetresonanzeinrichtung, ein System, ein Steuersystem und eine Magnetresonanzanlage.

Die Magnetresonanztomographie ist ein weitverbreitetes Verfahren der medizinischen Bildgebung. Typischerweise wird für die Magnetresonanztomographie eine Magnetresonanzanlage verwendet, welche eine Magnetresonanzeinrichtung und ein Steuersystem aufweist. Das Steuersystem weist üblicherweise eine Steuervorrichtung, insbesondere ein Steuermodul, ein Peripheriemodul und ein Empfangsmodul, auf. Das Steuermodul weist typischerweise Komponenten zu einem Steuern der Magnetresonanzeinrichtung auf und das Empfangsmodul ist zu einem Erfassen von hochfrequenten Magnetresonanzsignalen ausgebildet. Je nach Ausführung der Magnetresonanzanlage ist das Steuersystem typischerweise in einem Technikraum angeordnet.

Eine Implementierung des Steuersystems ist in einem Produktprozess eine vielschichtige Aufgabenstellung. Eine Architektur des Steuersystems kann auf mehreren Arten aufgebaut sein. Dabei ist es heutzutage üblich, die Steuersysteme gemäß den Anforderungen einer Magnetresonanzeinrichtung oder einer Produktlinie an Magnetresonanzeinrichtungen dediziert und spezifisch zu implementieren, obwohl viele Magnetresonanzeinrichtungen ähnliche Ausgestaltungseigenschaften aufweisen. Die verschiedenen konkreten Realisierungen von Steuersystemen unterscheiden sich in ihrer Architektur in der Regel sehr stark, woraus eine geringe Wiederverwertbarkeit und ein entsprechend höherer Entwicklungsaufwand für mehrere unterschiedliche Steuersysteme resultieren. Beispielsweise ist bei für preiswerte Magnetresonanzeinrichtungen entwickelten Steuersystemen häufig eine Begrenzung der Zahl der Empfangskanäle vorgesehen.

In der DE 10 2015 213 269 A1 ist ein modulares Baukastensystem zur Herstellung einer eine als Hardware realisierte Echtzeiteinheit aufweisenden Steuereinrichtung für eine Magnetresonanzeinrichtung aus einer Gruppe möglicher, unterschiedliche Ausgestaltungseigenschaften aufweisenden Magnetresonanzeinrichtungen offenbart.

Der Erfindung liegt die Aufgabe zu Grunde, eine platzsparende und erweiterbare Steuervorrichtung für eine Magnetresonanzeinrichtung, ein verbessertes Steuersystem und eine Magnetresonanzanlage mit einem erhöhten Grad an Wiederverwertbarkeit anzugeben.

Die Aufgabe wird durch die Merkmale der unabhängigen Ansprüche gelöst. Vorteilhafte Ausgestaltungen sind in den Unteransprüchen beschrieben.

Die erfindungsgemäße Steuervorrichtung für eine Magnetresonanzeinrichtung weist
- ein Steuermodul,
- ein Peripheriemodul,
- einen Empfangsmodulanschluss und
- eine Hauptplatineneinheit auf,
   wobei das Steuermodul
- eine zentrale Koordinationskomponente, welche zu einer Entgegennahme von gemäß einer Messsequenz berechneten Sequenzbefehlen ausgebildet ist,
- eine Hochfrequenzsteuerkomponente, welche zu einem Ansteuern einer Hochfrequenzsendeeinheit der Magnetresonanzeinrichtung gemäß den Sequenzbefehlen ausgebildet ist, und
- eine Gradientenspulensteuerkomponente, welche zu einem Ansteuern einer Gradientenspuleneinheit der Magnetresonanzeinrichtung gemäß den Sequenzbefehlen ausgebildet ist, aufweist,
- wobei das Peripheriemodul zu einem Ansteuern von Peripherieeinrichtungen der Magnetresonanzeinrichtung ausgebildet ist,
- wobei das Steuermodul und das Peripheriemodul Echtzeitanforderungen erfüllen,
- wobei der Empfangsmodulanschluss zu einem Anschließen eines Empfangsmoduls ausgebildet ist,
   dadurch gekennzeichnet,
- dass das Steuermodul, das Peripheriemodul und der Empfangsmodulanschluss in die Hauptplatineneinheit integriert sind.

Die Steuervorrichtung kann eine Integration einer Grundmenge an Funktionalitäten ermöglichen, welche zum Produktlinienübergreifenden Steuern einer Magnetresonanzeinrichtung dienen. Durch diese Integration sind vorzugsweise eine hohe Wiederverwertbarkeit und eine platzsparende Bauweise sichergestellt, wobei gleichzeitig die Steuervorrichtung je nach konkreter Ausgestaltung der Magnetresonanzeinrichtung entsprechend erweiterbar ist. Ein weiterer technischer Effekt ist insbesondere, dass wegen der Integration des Steuermoduls und des Peripheriemoduls in die Hauptplatineneinheit vorzugsweise ein Logikbaustein optimal ausgelastet und effizient betrieben werden können, insbesondere wenn beispielsweise in dem Logikbaustein insbesondere eine Logik des Steuermoduls und des Peripheriemoduls gemeinsam abgebildet sind. Die jeweilige Logik entspricht insbesondere einem jeweiligen logischen Teil des Steuermoduls und/oder des Peripheriemoduls. Des Weiteren fällt insbesondere ein Bedarf an einer technischen und damit oft hochpreisigen Verkabelung, welche das Steuermodul, das Peripheriemodul und/oder den Empfangsmodulanschluss jeweils untereinander verbindet, geringer aus. Die hohe Wiederverwertbarkeit bringt sich beispielsweise positiv bei einer Kostenreduktion der Steuervorrichtung durch höhere Stückzahlen ein.

Die Echtzeitanforderungen erfordern von dem jeweiligen Modul bzw. von der jeweiligen Komponente insbesondere eine rechtzeitige Ausgabe und/oder ein rechtzeitiges Übertragen eines berechneten Werts und/oder eines Steuersignals in einem festgelegten Zeitraum. Dass das jeweilige Modul die Echtzeitanforderungen erfüllt bedeutet demnach insbesondere, dass das jeweilige Modul in dem festgelegten Zeitraum nach Erhalt eines Eingangssignals die rechtzeitige Ausgabe des berechneten Werts und/oder des Steuersignals durchführen kann. In diesem Fall wird typischerweise das jeweilige Modul echtzeitfähig genannt. Wenn beispielsweise der festgelegte Zeitraum kleiner 10 ns ist, werden diese Echtzeitanforderungen insbesondere hart und/oder taktgenau genannt. Besonders vorteilhaft ist, wenn der festgelegte Zeitraum kleiner 0,01 ns ist. Das Peripheriemodul kann härtere Echtzeitanforderungen als das Steuermodul erfüllen und umgekehrt. Weiche Echtzeitanforderungen hingegen erfordern die rechtzeitige Ausgabe üblicherweise nach einem vergleichsweise längeren Zeitraum.

Alternativ oder zusätzlich können die Echtzeitanforderungen eine unmittelbare Ausgabe beispielsweise des Steuersignals bedingen. In diesem Zusammenhang wird insbesondere von Sofortzeitanforderungen (engl. immediate time) und/oder besonders harten Echtzeitanforderungen gesprochen. Vorzugsweise gehen die Sofortzeitanforderungen über die besonders harten, insbesondere ultra kurzen, Echtzeitanforderungen insofern hinaus, weil eine Sofortzeit-Komponente, welche die Sofortzeitanforderungen erfüllt, insbesondere keinerlei Bewusstsein bzw. Kontrolle über die Zeit hat, sondern Befehle unmittelbar ausführt sowie Signale schaltet. In diesem Fall kann eine Latenz der Sofortzeit-Komponente gemessen und beispielsweise in der Logik des Steuermoduls kompensiert werden. Vorzugsweise ist ein Jitter der Sofortzeit-Komponente gering.

Typischerweise weisen das Steuermodul und das Peripheriemodul jeweils einen physischen Teil und einen logischen Teil auf. Der logische Teil entspricht insbesondere der jeweiligen Logik. Die jeweilige Logik ist vorzugsweise zu einem Steuern des jeweiligen physischen Teils ausgebildet. Der physische Teil kann beispielsweise Leitungen, Schalter, Konnektivität, Mikrocontroller und/oder Anschlüsse aufweisen. Üblicherweise erfüllen logische Teile eher die weichen oder harten Echtzeitanforderungen, während die physischen Teile eher die Sofortzeitanforderungen erfüllen können. Beispielsweise ist es denkbar, dass der logische Teil die harten Echtzeitanforderungen und gleichzeitig der physische Teil die Sofortzeitanforderungen erfüllt. Der logische Teil befindet sich in diesem Fall insbesondere in einer anderen zeitlichen Domäne als der physische Teil. Bei einer Verbindung der unterschiedlichen zeitlichen Domänen kann eine zeitliche Abstimmung oder Synchronisierung nötig sein.

Allgemein gilt, abhängig von dem festgelegten Zeitraum bzw. von der zeitlichen Domäne kann eine Software und/oder eine reine Hardware die Echtzeitanforderungen, insbesondere die Sofortzeitanforderungen, erfüllen. Für weiche Echtzeitanforderungen können häufig Standardsysteme, beispielsweise ein handelsüblicher Personal Computer mit einer handelsüblichen Recheneinheit und Speichereinheit, verwendet werden. Ein solches Standardsystem weist beispielsweise ein Microsoft Windows oder ein Linux Betriebssystem auf, welche üblicherweise mit Software-Echtzeiterweiterungen ergänzt werden. Die Software-Echtzeiterweiterungen sind typischerweise echtzeitfähig und erfüllen insbesondere die weichen Echtzeitanforderungen. Für ein Zusammenspiel zwischen Software und Hardware können speziell angepasste Treiber nötig sein. Die harten Echtzeitanforderungen erfordern insbesondere spezielle Architekturen der Hardware und/oder entsprechende Programme und Betriebssysteme der Software. Ein Beispiel für die spezielle Architektur der Hardware kann der Logikbaustein sein. Üblicherweise ist ein Aufwand für ein Einrichten und Betreiben solcher Hardware und Software kostspieliger im Vergleich zur der handelsüblichen Ware. Beispielsweise kann jeweils der logische Teil des Steuermoduls und/oder des Peripheriemoduls in dem einzelnen Logikbaustein abgebildet sein. In anderen Worten weist der Logikbaustein den logischen Teil auf.

Das Steuermodul und das Peripheriemodul erfüllen die Echtzeitanforderungen insbesondere für ein zeitgenaues Ansteuern der entsprechenden Einheiten der Magnetresonanzeinrichtung. Grundsätzlich ist es denkbar, dass das Steuermodul beispielsweise die harten Echtzeitanforderungen erfüllt und das Peripheriemodul die besonders harten Echtzeitanforderungen bzw. die Sofortzeitanforderungen erfüllt.

Typischerweise gibt das Steuermodul, insbesondere die Hochfrequenzsteuerkomponente und die Gradientenspulensteuerkomponente, Steuersignale an die anzusteuernden Hochfrequenzsendeeinheit und Gradientenspuleneinheit der Magnetresonanzeinrichtung aus. Normalerweise kann das Steuermodul, insbesondere die Hochfrequenzsteuerkomponente und die Gradientenspulensteuerkomponente, die Hochfrequenzsendeeinheit bzw. die Gradientenspuleneinheit zeitgenau, koordiniert und taktgenau mit den Steuersignalen gemäß den Sequenzbefehlen ansteuern. Die Steuersignale können insbesondere digital sein. Zwischen der Hochfrequenzsteuerkomponente und der Hochfrequenzsteuereinheit sowie zwischen der Gradientenspulensteuerkomponente und der Gradientenspuleneinheit kann jeweils ein Digital-AnalogWandler sowie ein Hochfrequenzverstärker bzw. ein Gradientenspulenverstärker eingerichtet sein, wobei der Digital-AnalogWandler typischerweise kein Bestandteil der Steuervorrichtung ist. Mittels des Hochfrequenzverstärkers und des Gradientenspulenverstärkers können vorzugsweise die jeweiligen Steuersignale verstärkt werden. In diesem Fall entsprechen die Steuersignale insbesondere Spulenstromformen. Das Steuermodul kann zusätzlich eine Shimspulensteuerkomponente aufweisen, welche zu einem Ansteuern einer Shimspuleneinheit der Magnetresonanzeinrichtung gemäß den Sequenzbefehlen ausgebildet ist.

Die zentrale Koordinationskomponente ist insbesondere mit der Hochfrequenzsteuerkomponente und der Gradientenspulensteuerkomponente mittels einer Signalleitung verbunden. Die zentrale Koordinationskomponente kann vorzugsweise mit dem Peripheriemodul verbunden sein.

Die Messsequenz wird üblicherweise von einem Nutzer festgelegt und umfasst insbesondere eine Parametrisierung einer Messung einer bildgebenden Untersuchung eines Patienten. Die Messsequenz kann auch die Parametrisierung mehrerer Messungen aufweisen, beispielsweise eines Lokalizers, einer T1- und einer T2-Messung. Der Lokalizer dient üblicherweise zu einem Erfassen von Übersichtsbildern. Die T1- oder die T2-Messung können je nach Anwendungsfall unterschiedlich parametrisiert sein. Weitere Messungen und auch Wiederholungen der Messungen sind denkbar. Die Messsequenz kann insbesondere einem zeitlichen Ablauf der Messungen entsprechen, wobei der zeitliche Ablauf insbesondere von dem Nutzer festgelegt werden kann.

Die Sequenzbefehle sind insbesondere als Anweisungen an das Steuermodul für ein Ansteuern der Magnetresonanzeinrichtung gemäß der Messsequenz zu verstehen. Die Sequenzbefehle umfassen daher insbesondere eine zeitliche Koordination einer Reihenfolge von Hochfrequenzpulsen und Gradientenfeldern. Die zentrale Koordinationskomponente führt vorzugsweise die zeitliche Koordination aus und veranlasst ein Aussenden der Hochfrequenzpulse und der Gradientenfelder gemäß der festgelegten Reihenfolge in der jeweiligen Komponente. Die Reihenfolge der Hochfrequenzpulsen und Gradientenfeldern ist insbesondere für die Messsequenz charakteristisch. Insbesondere die Steuersignale weisen die Hochfrequenzpulse und/oder die Gradientenfelder auf. Die Hochfrequenzpulse werden beispielsweise von der Hochfrequenzsteuerkomponente gemäß den Sequenzbefehlen entworfen und mittels der Hochfrequenzsendeeinheit in der Magnetresonanzeinrichtung ausgesendet. Eine Frequenz der Hochfrequenzpulse liegt insbesondere im Radio-Frequenz-Bereich. Die Gradientenfelder werden üblicherweise von der Gradientenspulensteuerkomponente gemäß den Sequenzbefehlen entworfen und mittels der Gradientenspuleneinheit in der Magnetresonanzeinrichtung erzeugt. Die Gradientenfelder sind typischerweise magnetische Felder und dienen einer Variierung eines Hauptmagnetfelds der Magnetresonanzeinrichtung. Das Hauptmagnetfeld wird üblicherweise von einer Hauptmagnetfeldeinheit der Magnetresonanzeinrichtung erzeugt.

Das Peripheriemodul ist mit dem Steuermodul, insbesondere der zentralen Koordinationskomponente, verbunden. Das Peripheriemodul ist beispielsweise mit dem Steuermodul mittels eines Lichtwellenleiters für das Peripheriemodul und/oder einer weiteren Signalleitung verbunden. Die Peripherieeinrichtungen sind üblicherweise dezentrale Einheiten der Magnetresonanzeinrichtung, welche beispielsweise nicht ortsfest und/oder nicht für jede bildgebende Untersuchung benötigt werden. Die Peripherieeinrichtungen der Magnetresonanzeinrichtungen weisen beispielsweise eine Patientenliege, eine Kommunikationseinrichtung für den Patienten, eine EKG-Messeinrichtung (EKG = Echo-Kardiogramm), einen Türkontakt eines Untersuchungsraum, in welchem die Magnetresonanzeinrichtung angeordnet ist, eine Temperaturerfassung, eine Lüftung sowie ein Licht für den Patienten oder dergleichen auf. Je nach Ausgestaltung der Magnetresonanzeinrichtung können die Peripherieeinrichtungen eine Shimeinrichtung aufweisen. Die Peripherieeinrichtungen können jeweils unterschiedliche Echtzeitanforderungen erfordern und sind insbesondere mit dem Peripheriemodul verbunden. Beispielsweise kann das Peripheriemodul von der verbunden EKG-Messeinrichtung EKG-Signale empfangen und an das Steuermodul übertragen. Vorzugsweise kann das Steuermodul die Sequenzbefehle an die EKG-Signale anpassen. Dies ist insofern vorteilhaft, wenn beispielsweise mittels einer Messung in der Magnetresonanzeinrichtung ein Thorax des Patienten erfasst wird, weil der Thorax üblicherweise sich in Abhängigkeit eines Herzrhythmus des Patienten bewegt und durch diese Bewegung Bildartefakte entstehen können. Die EKG-Signale können vorzugsweise den Herzrhythmus ermitteln und die Sequenzbefehle können an den Herzrhythmus gemäß den EKG-Signalen angepasst und damit die Bildartefakte zumindest teilweise vermieden werden. Im Vergleich zu einem Positionieren der Patientenliege, welches üblicherweise gemäß den Sofortzeitanforderungen erfolgt, erfüllt das Peripheriemodul insbesondere für das Übertragen der EKG-Signale die weichen Echtzeitanforderungen. Das Steuermodul kann beispielsweise Atemanweisungen gemäß den Sequenzbefehlen an die Kommunikationseinrichtung übertragen und mittels der Kommunikationseinrichtung aussenden.

Je nach bildgebender Untersuchung kann eine Empfangsspuleneinheit der Magnetresonanzeinrichtung variiert und typischerweise von dem Nutzer vor Ort ausgetauscht werden. Beispielsweise ist eine Kopfspule anders ausgeführt als eine Abdomenspule, wobei mittels der Kopfspule vorzugsweise ein Kopf des Patienten und mittels der Abdomenspule ein Abdomen des Patienten optimal erfasst werden können. Die Empfangsspuleneinheit weist typischerweise eine variierende Anzahl an Spulenelementen auf, wobei typischerweise für jedes Spulenelement ein separater Empfangskanal vorgesehen ist. Grundsätzlich korrelieren eine Bildqualität und damit auch die Anschaffungskosten der Empfangsspuleneinheit mit der Anzahl an Empfangskanälen.

Das Empfangsmodul, insbesondere der physische Teil des Empfangsmoduls, ist vorzugsweise mittels eines Übertragungskabels mit dem Empfangskanal der Empfangsspuleneinheit der Magnetresonanzeinrichtung verbindbar. Je nach Ausführung der Empfangsspuleneinheit kann der Empfangskanal dem physischen Spulenelement oder lediglich einer Verbindungsleitung zu dem physischen Spulenelement entsprechen. In jedem Fall ist der Empfangskanal zu einem Übertragen der empfangenen hochfrequenten Magnetresonanzsignale ausgebildet. Das Empfangsmodul erfasst üblicherweise einen kontinuierlichen Strom der hochfrequenten Magnetresonanzsignale. Üblicherweise ist zwischen dem Empfangsmodul und dem Empfangsspuleneinheit ein Analog-Digital-Wandler eingerichtet. Der Analog-Digital-Wandler ist vorzugsweise kein Bestandteil der Steuervorrichtung. Im Wesentlichen arbeitet die Steuervorrichtung mit digitalen Signalen. Vorteilhafterweise kann das Empfangsmodul derart an das Steuermodul angeschlossen werden, dass insbesondere die zentrale Koordinationskomponente gemäß den Sequenzbefehlen dem Empfangsmodul einen Auslese-Zeitraum für ein zeitlich abgestimmtes Empfangen der hochfrequenten Magnetresonanzsignale vorgeben kann. Alternativ oder zusätzlich ist das Empfangsmodul zu einer Datenreduktion der hochfrequenten Magnetresonanzsignale und/oder einem Vorverarbeiten ausgebildet. Ein Übertragen der hochfrequenten Magnetresonanzsignale erfolgt insbesondere unmittelbar in einem Datenstrom von der Magnetresonanzeinrichtung an die Steuervorrichtung. Diese Übertragung erfolgt insbesondere ohne Bezug zu der Zeit, d.h. insbesondere gemäß den Sofortzeitanforderungen.

Der Empfangsmodulanschluss kann beispielsweise als Einsteckkartenanschluss für eine Einsteckkarte ausgebildet sein. Die Einsteckkarte ist in diesem Fall vorzugsweise als das Empfangsmodul ausgebildet. Der Einsteckkartenanschluss und die Einsteckkarte können insbesondere den "Peripheral Component Interconnect Express" PCIe-Standard oder einen anderen vergleichbaren Standard erfüllen. Grundsätzlich ist es denkbar, dass der Einsteckkartenanschluss und die Einsteckkarte einen individuell von einem Hersteller der Steuervorrichtung entwickelten Standard erfüllen. Alternativ kann der Empfangsmodulanschluss als Lichtwellenleiteranschluss für einen Lichtwellenleiter der Einsteckkarte ausgebildet sein. In diesem Fall ist der Lichtwellenleiteranschluss mit dem Lichtwellenleiter der Einsteckkarte verbindbar. Auch weitere kabelgebundene Verbindungen zwischen der Einsteckkarte und dem Empfangsmodulanschluss sind denkbar. Grundsätzlich ist es möglich, dass die Steuervorrichtung einen weiteren Empfangsmodulanschluss aufweist, der beispielsweise anders als der Empfangsmodulanschluss ausgeführt ist. Beispielsweise ist es denkbar, dass der Empfangsmodulanschluss den Einsteckkartenanschluss und der weitere Empfangsmodulanschluss einen kabelgebunden Anschluss aufweist.

Die Hauptplatineneinheit weist insbesondere zumindest eine Leiterplatte auf, wobei die zumindest eine Leiterplatte das Steuermodul, das Peripheriemodul und den Empfangsmodulanschluss elektrisch verbindet. Das Steuermodul, das Peripheriemodul und der Empfangsmodulanschluss sind insbesondere auf der zumindest einen Leiterplatte mechanisch befestigt und beispielsweise mittels Leiterbahnen der zumindest einen Leiterplatte verbunden. Alternativ oder zusätzlich zu den Leiterbahnen sind weitere Signalleitungen denkbar, welche nicht in die zumindest eine Leiterplatte integriert sind. Beispielsweise können das Steuermodul und das Peripheriemodul mittels des Lichtwellenleiters für das Peripheriemodul verbunden sein.

Das Steuermodul, das Peripheriemodul und der Empfangsmodulanschluss können je nach Ausgestaltung lose oder stark in die Hauptplatineneinheit integriert sein. Die lose Integration entspricht insbesondere lediglich einer typischerweise kabelgebundenen Verbindung von dem Steuermodul, dem Peripheriemodul und dem Empfangsmodulanschluss, welche jeweils auf einer separaten Leiterplatte oder einer separaten Hardware-Baueinheit ausgebildet sind. Die starke Integration kann bedeuten, dass das Steuermodul, das Peripheriemodul und der Empfangsmodulanschluss auf einer einzigen Leiterplatte und zwar auf der zumindest einen Leiterplatte zusammen angeordnet sind. Auch Mischformen zwischen der losen und der starken Integration, bei denen jeweils verschiedene Module zusammengefasst und elektrisch verbunden werden, sind denkbar. Das Steuermodul, das Peripheriemodul und der Empfangsmodulanschluss bilden insbesondere die Hauptplatineneinheit und damit vorzugsweise eine physisch zusammenhängende oder abgeschlossene Einheit. Die kabelgebundene Verbindung kann beispielsweise für ein Übertragen der Leistung, der Steuersignale, der Sequenzbefehle und/der der hochfrequenten Magnetresonanzsignale ausgebildet sein.

Eine Ausführungsform sieht vor, dass die Steuervorrichtung eine Zeitabstimmungskomponente aufweist und dass die Zeitabstimmungskomponente in die Hauptplatineneinheit integriert ist und zu einem Ausgeben eines Taktsignals sowie zu einem zeitlichen Abstimmen des Steuermoduls, des Peripheriemoduls und des Empfangsmodulanschlusses mittels des Taktsignals ausgebildet ist. Das Taktsignal ist insbesondere ein binäres Signal. Das zeitliche Abstimmen entspricht typischerweise einem zeitlichen Synchronisieren des Steuermoduls und des Peripheriemoduls. Üblicherweise wird mittels der Zeitabstimmungskomponente ein Erfüllen der Echtzeitanforderungen vereinfacht. Die Zeitabstimmungskomponente ist vorzugsweise mit dem Steuermodul, dem Peripheriemodul, insbesondere mit deren jeweiligen logischen Teil, und dem Empfangsmodulanschluss verbunden. Wenn das Empfangsmodul an dem Empfangsmodulanschluss angeschlossen ist, kann die Zeitabstimmungskomponente vorzugsweise das Empfangsmodul mittels des Taktsignals abstimmen. Die zentrale Koordinationskomponente kann vorzugsweise mittels des Taktsignals die Reihenfolge der Hochfrequenzpulse und der Gradientenfelder sowie den Auslese-Zeitraum festlegen und überwachen.

Eine Ausführungsform sieht vor, dass die Steuervorrichtung einen FPGA aufweist, wobei der FPGA als eine einzige Hardware-Baueinheit ausgebildet ist, und dass das Steuermodul und/oder das Peripheriemodul in dem FPGA abgebildet sind. Die Hardware-Baueinheit ist vorzugsweise stückweise hergestellt und bildet insbesondere eine zusammengehörende Einheit, welche beispielsweise mittels eines Hardware-Gehäuses abgeschlossen ist. Typischerweise wird der FPGA als integrierter Schaltkreis bezeichnet, welcher gemäß einer vorgegebenen Logik oder Programmcodemitteln konfiguriert werden kann. Der FPGA (Field Programmable Gate Array) erfüllt vorzugsweise die Echtzeitanforderungen, kann dem Logikbaustein entsprechen und/oder mit der Zeitabstimmungskomponente für ein Empfangen des Taktsignals verbunden sein. Vorteilhafterweise ist die Logik, insbesondere der logische Teil, des Peripheriemoduls und des Steuermoduls ganz oder zumindest teilweise in dem FPGA abgebildet. Alternativ ist lediglich der logische Teil entweder des Peripheriemoduls oder des Steuermoduls in dem FPGA abgebildet.

Eine Ausführungsform sieht vor, dass die Steuervorrichtung ein integriertes Empfangsmodul aufweist und dass das integrierte Empfangsmodul zu einem Erfassen von mittels des Empfangskanals der Empfangsspuleneinheit der Magnetresonanzeinrichtung empfangenen hochfrequenten Magnetresonanzsignalen ausgebildet ist, die Echtzeitanforderungen erfüllt und in die Hauptplatineneinheit integriert ist. Das integrierte Empfangsmodul kann im Wesentlichen dem Empfangsmodul, welches an dem Empfangsmodulanschluss anschließbar ist, entsprechen. Ein Unterschied wird üblicherweise eine bauliche Ausführung sein. Das integrierte Empfangsmodul ist vorzugsweise fest in die Hauptplatineneinheit integriert, während das Empfangsmodul beispielsweise in die Einsteckkarte integriert ist, wobei die Einsteckkarte mittels des Empfangsmodulanschlusses mit der Steuervorrichtung insbesondere lösbar verbunden ist.

Eine Ausführungsform sieht vor, dass das integrierte Empfangsmodul in dem FPGA abgebildet ist und der FPGA zu einem Filtern der hochfrequenten Magnetresonanzsignale ausgebildet ist. Die Abbildung des integrierten Empfangsmoduls, inbesondere einer Logik des integrierten Empfangsmoduls in dem FPGA, in welchem beispielsweise der jeweilige logische Teil des Steuermoduls und/oder des Peripheriemoduls bereits abgebildet ist, ist insbesondere in Hinblick auf eine optimale Auslastung des FPGAs vorteilhaft und kann darüber hinaus eine einfachere Kommunikation zwischen dem integrierten Empfangsmodul, dem Steuermodul und dem Peripheriemodul ermöglichen. Grundsätzlich ist es denkbar, dass die Steuervorrichtung einen weiteren FPGA aufweist, in welchem beispielsweise die Logik des integrierten Empfangsmoduls abgebildet ist und lediglich der jeweilige logische Teil des Steuermoduls und/oder des Peripheriemoduls sind in dem FPGA abgebildet. In einer besonders bevorzugten Ausführung ist allerdings die Logik des Steuermoduls, des Peripheriemoduls und des integrierten Empfangsmoduls in einem einzigen FPGA abgebildet.

Das Filtern der hochfrequenten Magnetresonanzsignale kann insbesondere eine Reduktion, ein algorithmisches Vorverarbeiten und/oder eine Frequenzmodulation der hochfrequenten Magnetresonanzsignale umfassen. Das Filtern kann insbesondere einem Auslesen der hochfrequenten Magnetresonanzsignale gemäß dem Auslese-Zeitraum entsprechen. Das Auslesen kann beispielsweise einem Ausstanzen der hochfrequenten Magnetresonanzsignale und damit einem Trennen von für eine Bildrekonstruktion relevanten und irrelevanten hochfrequenten Magnetresonanzsignalen bedeuten. Mittels des FPGAs werden üblicherweise die hochfrequenten Magnetresonanzsignale effizient und schnell vorverarbeitet und/oder gefiltert.

Eine Ausführungsform sieht vor, dass das integrierte Empfangsmodul einen Lichtwellenleiteranschluss aufweist, wobei der Lichtwellenleiteranschluss zu einem Anschließen des Empfangskanals der Empfangsspuleneinheit der Magnetresonanzeinrichtung und zu einem Übertragen der hochfrequenten Magnetresonanzsignale von dem Empfangskanal der Empfangsspuleneinheit an das Empfangsmodul ausgebildet ist. Typischerweise ist ein Lichtwellenleiter für das integrierte Empfangsmodul an dem Lichtwellenleiteranschluss angeschlossen und mit dem Empfangskanal der Empfangsspuleneinheit verbunden. Insbesondere der physische Teil des integrierten Empfangsmoduls kann dem Lichtwellenleiteranschluss entsprechen. In diesem Fall ist der Lichtwellenleiter für das integrierte Empfangsmodul als das Übertragungskabel zwischen dem integrierten Empfangsmodul und dem Empfangskanal der Empfangsspuleneinheit und zu dem Übertragen der hochfrequenten Magnetresonanzsignale ausgebildet. Neben optischen Leitern sind beispielsweise elektrische Leiter oder auch andere dem Fachmann bekannte Leiter denkbar. Wenn das integrierte Empfangsmodul den Lichtwellenleiteranschluss und den FPGA aufweist, dann ist vorzugsweise die Logik des integrierten Empfangsmoduls in dem FPGA abgebildet und der physische Teil des integrierten Empfangsmoduls, wie beispielsweise der Lichtwellenleiteranschluss, ist außerhalb des FPGAs anschließbar. Der Lichtwellenleiter für das integrierte Empfangsmodul kann typischerweise 4-8 Lichtwellenleiterkanäle aufweisen.

Grundsätzlich sind daher im Wesentlichen drei Ausführungsarten der Steuervorrichtung im Hinblick auf das Erfassen der hochfrequenten Magnetresonanzsignale denkbar: 1) die Steuervorrichtung ist mit dem Empfangsmodul am Empfangsmodulanschluss erweitert, 2) die Steuervorrichtung weist das integrierte Empfangsmodul auf und 3) die Steuervorrichtung weist das integrierte Empfangsmodul auf sowie wird mit dem Empfangsmodul am Empfangsmodulanschluss erweitert. Diese Modularität ist insbesondere in Hinblick auf eine Skalierung der Steuervorrichtung relativ zu einer Anzahl der Empfangskanäle der Empfangsspuleneinheit vorteilhaft.

Das erfindungsgemäße System weist die Steuervorrichtung und das Empfangsmodul auf, wobei die Empfangsspuleneinheit der Magnetresonanzeinrichtung den Empfangskanal aufweist und wobei das Empfangsmodul mittels des Empfangsmodulanschlusses an die Hauptplatineneinheit angeschlossen ist und zu einem Erfassen von mittels des Empfangskanals der Empfangsspuleneinheit der Magnetresonanzeinrichtung empfangenen hochfrequenten Magnetresonanzsignalen ausgebildet ist. In anderen Worten ist die Steuervorrichtung mit dem Empfangsmodul an dem Empfangsmodulanschluss erweitert bzw. ergänzt.

Je mehr Empfangskanäle die Empfangsspuleneinheit aufweist, desto mehr hochfrequente Magnetresonanzsignale werden empfangen und müssen typischerweise von dem Empfangsmodul und/oder dem integrierten Empfangsmodul verarbeitet werden. Die Anzahl der Empfangskanäle variiert allerdings von Ausgestaltung zu Ausgestaltung der Magnetresonanzeinrichtung. Die Steuervorrichtung benötigt daher üblicherweise entweder das angeschlossene Empfangsmodul und/oder das integrierte Empfangsmodul. Das System erfüllt den technischen Effekt, dass die Steuervorrichtung einfach um das Empfangsmodul erweitert und gleichzeitig das Empfangsmodul von der Steuervorrichtung, insbesondere von dem Steuermodul, gesteuert werden kann. Dies ermöglicht je nach Ausgestaltung eine platzsparende Steuervorrichtung und dennoch ein modulares System.

Mittels des Empfangsmodulanschlusses ist das Empfangsmodul vorzugsweise elektrisch mit dem Steuermodul und dem Peripheriemodul verbunden. Mittels dieser Verbindung kann insbesondere Leistung, die hochfrequenten Magnetresonanzsignale, die Steuersignale und/oder die Sequenzbefehle übertragen und ausgetauscht werden.

Eine Ausführungsform sieht vor, dass das Empfangsmodul einen Lichtwellenleiteranschluss und einen FPGA aufweist, wobei der Lichtwellenleiteranschluss zu einem Anschließen des Empfangskanals der Empfangsspuleneinheit der Magnetresonanzeinrichtung ausgebildet ist und wobei der FPGA des Empfangsmoduls zu einem Filtern der hochfrequenten Magnetresonanzsignale ausgebildet ist. Der logische Teil des Empfangsmoduls ist in dem FPGA abgebildet und der physische Teil entspricht insbesondere dem Lichtwellenleiteranschluss. Es ist denkbar, dass das Empfangsmodul eine weitere Leiterplatte aufweist, in welchen beispielsweise der FPGA integriert ist. Die weitere Leiterplatte kann mit der Steuervorrichtung mittels des Empfangsmodulanschluss und/oder drahtgebunden verbunden und gleichzeitig an dem Empfangskanal der Empfangsspuleneinheit angeschlossen sein.

Grundsätzlich ist es denkbar, wenn die Steuervorrichtung zusätzlich das integrierte Empfangsmodul aufweist, dass das integrierte Empfangsmodul und das Empfangsmodul die hochfrequenten Magnetresonanzsignale erfassen und/oder austauschen können. Beispielsweise dient das Empfangsmodul lediglich zum Erfassen der hochfrequenten Magnetresonanzsignale und leitet diese an das integrierte Empfangsmodul für ein Vorverarbeiten und/oder Filtern weiter.

Eine Ausführungsform sieht vor, dass die Empfangsspuleneinheit der Magnetresonanzeinrichtung zusätzlich zu dem Empfangskanal einen weiteren Empfangskanal aufweist, wobei das Empfangsmodul zu einem Erfassen von mittels des weiteren Empfangskanals der Empfangsspuleneinheit der Magnetresonanzeinrichtung empfangenen hochfrequenten Magnetresonanzsignalen ausgebildet ist. In dieser Ausführungsform sind das integrierte Empfangsmodul und das Empfangsmodul jeweils mit unterschiedlichen Empfangskanälen verbindbar. Grundsätzlich ist es denkbar, dass das integrierte Empfangsmodul mit dem Empfangskanal und dem weiteren Empfangskanal beispielsweise mittels des Lichtwellenleiters und/oder mehrerer Lichtwellenleiter verbunden ist. In diesem Fall kann das Empfangsmodul mit einem dritten Empfangskanal und einem vierten Empfangskanal und/oder zusätzlichen Empfangskanälen verbindbar sein. In anderen Worten ist es insbesondere möglich, dass mit dem integrierten Empfangsmodul eine erste Anzahl an Empfangskanälen und mit dem Empfangsmodul eine zweite Anzahl an Empfangskanälen verbindbar ist. Beispielsweise kann das integrierte Empfangsmodul mit mehr oder weniger Empfangskanälen der Empfangsspuleneinheit der Magnetresonanzeinrichtung im Vergleich zum Empfangsmodul verbindbar sein. Das Empfangsmodul kann demnach eine Kapazität der Steuervorrichtung in Hinblick auf die Empfangskanäle der Empfangsspuleneinheit der Magnetresonanzeinrichtung vergrößern. Das Empfangsmodul kann im Wesentlichen analog zu dem integrierten Empfangsmodul ausgebildet sein.

Das erfindungsgemäße Steuersystem weist
- eine Schnittstelle,
- einen Personal Computer und
- die Steuervorrichtung auf,
- wobei der Personal Computer weichere Echtzeitanforderungen erfüllt als das Steuermodul und das Peripheriemodul,
- wobei der Personal Computer zu einem Berechnen der Sequenzbefehle gemäß der Messsequenz ausgebildet ist und ein Gehäuse aufweist,
- wobei die Schnittstelle drahtgebunden und zu einem Übertragen der Sequenzbefehle von dem Personal Computer an die zentrale Koordinationskomponente ausgebildet ist und
- wobei die Steuervorrichtung mittels der Schnittstelle mit dem Personal Computer verbunden ist und außerhalb des Gehäuses des Personal Computers angeordnet ist.

Eine starke Limitation von Steuersystemen aus dem Stand der Technik ist typischerweise eine sehr enge Verkopplung von einer Technologie des Personal Computers mit der Steuervorrichtung, welche bisher für jedes Magnetresonanzeinrichtung separat entwickelt und hergestellt werden musste. Die sehr enge Verkopplung ist beispielsweise aufgrund der Echtzeitanforderungen nötig. Beispielsweise wurde bisher ein Steuermodul direkt in den Personal Computer hineingesteckt. Zum einen ist die Anzahl der Steckplätze und insbesondere ein Platz innerhalb des Gehäuses des Personal Computers für eine derartige Einsteckkarte stark eingeschränkt, zum anderen ist aufgrund der Ausführung des Gehäuses eine Konnektivität des Steuermoduls aus dem Gehäuse hinaus limitiert. Üblicherweise werden die Steckplätze des Personal Computers für Rechenbeschleuniger, wie beispielsweise Grafikkarten, benötigt. Diese sehr enge Verkopplung führt insbesondere dazu, dass in einem Service-Fall oder im Rahmen von Service-Verträgen nach einem gewissen Zeitraum die gesamte Hardware, d.h. der Personal Computer mitsamt dem jeweiligen Steuermodul, Empfangsmodul und Peripheriemodul verworfen wird.

Der technische Effekt des erfindungsgemäßen Steuersystems ist insbesondere ein Aufweichen der sehr engen Verkopplung durch eine physische Trennung des Personal Computers von der Steuervorrichtung. Die Steuervorrichtung ist nunmehr außerhalb des Personal Computers angeordnet und vorzugsweise lediglich mittels der echtzeitfähigen Schnittstelle mit dem Personal Computer verbunden. Dies bietet typischerweise mehrere Vorteile:
- eine technische Ausgestaltung der Steuervorrichtung ist nicht durch eine räumliche Vorgabe des Gehäuses des Personal Computers eingeschränkt,
- die Steckkartenanschlüsse innerhalb des Gehäuses des Personal Computers können beispielsweise für die Rechenbeschleuniger verwendet werden,
- die Schnittstelle wird mit handelsüblichen Standard-Verbindungen realisiert und
- der Personal Computer kann vorzugsweise einer handelsüblichen und damit kostengünstigeren Variante entsprechen. Durch die Trennung sind weitere Kostenersparnisse möglich, weil die jeweiligen Module und Komponenten separat im Rahmen des Service-Vertrags oder im Service-Fall ausgetauscht werden können. Insbesondere die technische Ausgestaltung der Steuervorrichtung ermöglicht eine individuelle Skalierbarkeit gemäß der Magnetresonanzeinrichtung und hohe Synergieeffekte.

Der Personal Computer erfüllt daher insbesondere die weichen Echtzeitanforderungen. Ein festgelegter Zeitraum der weichen Echtzeitanforderungen ist insbesondere kleiner als 5 ms, vorzugsweise kleiner als 1 ms. Besonders vorteilhaft ist, wenn der festgelegte Zeitraum kleiner 0,5 ms ist. Dass der Personal Computer die weichen Echtzeitanforderungen erfüllt ist insbesondere vorteilhaft, wenn die Sequenzbefehle in einem kontinuierlichen Fluss von dem Personal Computer an die zentrale Koordinationskomponente mittels der Schnittstelle während der bildgebenden Untersuchung übertragen werden. Dadurch ist insbesondere eine zeitlich abgestimmte Übertragung möglich. Ein weiteres Beispiel kann ein Reagieren auf physiologische Signale des Patienten, welche mittels der Peripherieeinrichtungen erfasst werden, umfassen. Die vergleichsweise weicheren Echtzeitanforderungen können insbesondere genügen, weil der Personal Computer dem Steuermodul, dem Peripheriemodul und beispielsweise dem integrierten Empfangsmodul und/oder dem angeschlossenen Empfangsmodul übergeordnet ist und demnach der längere festgelegte Zeitraum ausreicht. In anderen Worten setzt die Steuervorrichtung, insbesondere das Steuermodul, im Vergleich zum Personal Computer zeitkritischere und höher zeitaufgelöste Aufgaben um.

Die Schnittstelle ist vorzugsweise derart eingerichtet, dass die Sequenzbefehle, welche von dem Personal Computer berechnet werden, an die zentrale Koordinationskomponente übertragen werden. Üblicherweise erfüllt die Schnittstelle die Echtzeitanforderungen, welche der Personal Computer erfüllt. Beispielsweise ist ein Treiber, welcher für ein Ansteuern der Schnittstelle verwendet wird, gemäß den Echtzeitanforderungen ausgebildet. Um die Echtzeitanforderungen erfüllen zu können, kann es notwendig sein, dass die Schnittstelle bestimmte physische Bedingungen erfüllt. Typischerweise kann die Schnittstelle nicht über eine beliebige räumliche Distanz die Echtzeitanforderungen erfüllen, beispielsweise aufgrund von Verlusten oder Latenzen beim Übertragen. Daher kann beispielsweise eine drahtgebundene Ausführung der Schnittstelle auf ca. 1 m Länge beschränkt sein. Die Schnittstelle ist üblicherweise für einen bi-direktionalen Datenaustausch ausgebildet.

Vorzugsweise entspricht der Personal Computer einer handelsüblichen Ausführung, welche üblicherweise kostengünstiger als eine speziell für das Steuersystem hergestellte Variante ist. Der Personal Computer verfügt daher üblicherweise einerseits über Standard-Komponenten und Schnittstellen, beispielsweise einer USB-Schnittstelle (USB = Universal Serial Bus) nach einem USB-Standard und/oder einer PCIe-Schnittstelle nach dem PCIe-Standard, andererseits über eingeschränkte Erweiterungsmöglichkeiten. Insbesondere die PCIe-Schnittstellen sind räumlich bedingt nur in geringer Anzahl vorhanden. Der Raum wird typischerweise durch das Gehäuse vorgegeben. Das Gehäuse umhüllt üblicherweise den Personal Computer, weist eine Kühlung für den Personal Computer auf und sieht eine gewisse Anzahl an Slotblechen vor, die beispielsweise einer Erweiterung des Personal Computers mit einer PCIe-Einsteckkarte dienen. Die Slotbleche dienen insbesondere einer Abdeckung einer Lücke des Gehäuses in der Nähe der Anschlüsse für die Einsteckkarten. Der Personal Computer ist demnach typischerweise aus verschiedenen Gründen bezüglich der Erweiterung eingeschränkt, allerdings insbesondere kostengünstig zu erwerben und einfach zu konfigurieren.

Die Schnittstelle weist typischerweise einen physischen Anschluss auf. Beispielsweise weist ein Mainboard des Personal Computers eine Recheneinheit, wobei die Recheneinheit vorzugsweise zum Berechnen der Sequenzbefehle ausgebildet ist, und den physischen Anschluss der Schnittstelle auf. In anderen Worten ist der physische Anschluss der Schnittstelle in das Mainboard des Personal Computers integriert bzw. an dem Mainboard befestigt. Das Mainboard ist insbesondere innerhalb des Gehäuses befestigt. Wenn der physische Anschluss in das Mainboard integriert ist, ist dieser typischerweise nach dem PCIe-Standard ausgebildet. Grundsätzlich ist auch denkbar, dass der physische Anschluss nicht wie in diesem Fall innerhalb des Gehäuses, sondern an dem Gehäuse angeordnet ist. Der handelsübliche Personal Computer weist beispielsweise USB-Anschlüsse auf, welche mit dem Mainboard verbunden sind, aber von außerhalb des Gehäuses anschließbar sind. In diesem Fall weist der USB-Anschluss insbesondere einen separaten physischen Anschluss gemäß dem USB-Standard auf.

Die Steuervorrichtung weist beispielsweise einen weiteren physischen Anschluss auf, wobei der weitere physische Anschluss beispielsweise an der Hauptplatineneinheit befestigt und mit dem Steuermodul, dem Peripheriemodul und dem Empfangsmodulanschluss elektrisch verbunden ist. Beispielsweise können mittels eines Kabels der physische Anschluss der Schnittstelle und der weitere physische Anschluss der Steuervorrichtung verbunden werden. Die Schnittstelle weist vorzugsweise das Kabel auf. Das Kabel erfüllt insbesondere die Echtzeitanforderungen des Personal Computers, wenn beispielsweise der Treiber entsprechend optimiert und/oder eine Länge des Kabels insbesondere nicht länger als 1 m ist. Das Kabel kann von Störfeldern abgeschirmt sein. Der physische Anschluss der Schnittstelle wird insbesondere mittels des Kabels verlängert und damit auch eine elektrische Verbindung zwischen der Recheneinheit und der Schnittstelle. Vorteilhafterweise ist das Kabel gemäß demselben technischen Standard ausgebildet, wie der physische Anschluss und die Schnittstelle. Alternativ oder zusätzlich können das Steuermodul, das integrierte Empfangsmodul, das Peripheriemodul und/oder das Empfangsmodul mittels separater Leitungen, welche in dem Kabel gebündelt sein können, mit dem Personal Computer verbindbar sein.

Eine Ausführungsform sieht vor, dass die Schnittstelle innerhalb des Gehäuses angeordnet ist. Beispielsweise ist das Kabel an dem physischen Anschluss des Mainboards angeschlossen. Vorzugsweise kann das Kabel aus dem Gehäuse des Personal Computers herausgeführt werden. In dieser Ausführung erfüllt die Schnittstelle beispielsweise den PCIe-Standard. Vorteilhafterweise kann mittels des Kabels die Einschränkung in Hinblick auf die Erweiterung des Personal Computers kosteneffizient und einfach gelockert werden.

Die Schnittstelle kann zu einem Übertragen der hochfrequenten Magnetresonanzsignale von dem integrierten Empfangsmodul oder dem angeschlossenen Empfangsmodul an den Personal Computer ausgebildet sein. Typischerweise weist das Empfangsmodul lediglich einen kleinen Buffer in einer Größenordnung von ein paar Megabyte für ein kurzfristiges Abspeichern der hochfrequenten Magnetresonanzsignale auf. Üblicherweise wird das integrierte Empfangsmodul und/oder das angeschlossene Empfangsmodul die hochfrequenten Magnetresonanzsignale unmittelbar an den Personal Computer übertragen.

Eine Ausführungsform sieht vor, dass das Steuersystem eine Massendatenschnittstelle aufweist, wobei die Steuervorrichtung mittels der Massendatenschnittstelle mit dem Personal Computer verbunden ist, wobei die Massendatenschnittstelle drahtgebunden und zu einem Übertragen der hochfrequenten Magnetresonanzsignale von der Steuervorrichtung an den Personal Computer ausgebildet ist und wobei die Schnittstelle im Vergleich zu der Massendatenschnittstelle härtere Echtzeitanforderungen erfüllt. Insbesondere von dem integrierten Empfangsmodul und/oder von dem angeschlossenen Empfangsmodul werden die hochfrequenten Magnetresonanzsignale mittels der Massendatenschnittstelle übertragen. In dieser Ausführungsform weist das Steuersystem, insbesondere der Personal Computer und die Steuervorrichtung, die Massendatenschnittstelle zusätzlich zu der Schnittstelle auf. In anderen Worten ist vorzugsweise die Steuervorrichtung und der Personal Computer mittels der Schnittstelle und der Massendatenschnittstelle gleichzeitig verbindbar. Grundsätzlich können die Massendaten und die Sequenzbefehle über die Schnittstelle und die Massendatenschnittstelle übertragen werden. Die Massendaten können beispielsweise die hochfrequenten Magnetresonanzsignale aufweisen. Üblicherweise ist die Massendatenschnittstelle im Vergleich zur Schnittstelle kostengünstiger und technisch einfacher. Vorzugsweise sind die Massendatenschnittstelle gemäß dem USB-Standard und die Schnittstelle gemäß dem PCIe-Standard ausgebildet. Die Schnittstelle, wenn diese gemäß dem PCIe-Standard ausgebildet ist, ist üblicherweise technisch bedingt besser für härtere Echtzeitanforderungen geeignet als die Massendatenschnittstelle, wenn diese gemäß dem USB-Standard ausgebildet ist.

Eine Ausführungsform sieht vor, dass der Personal Computer ein Rekonstruktionssystem aufweist, welches zu einer Rekonstruktion von Magnetresonanzbildern gemäß den hochfrequenten Magnetresonanzsignalen ausgebildet ist. Die hochfrequenten Magnetresonanzsignale werden vorzugsweise von dem integrierten Empfangsmodul und/oder dem angeschlossenen Empfangsmodul an das Rekonstruktionssystem übertragen. Wenn das Steuersystem die Massendatenschnittstelle aufweist, können die hochfrequenten Magnetresonanzbilder vorzugsweise mittels der Massendatenschnittstelle übertragen werden. Üblicherweise erfüllt das Rekonstruktionssystem keine Echtzeitanforderungen, weil die Rekonstruktion der Magnetresonanzbilder normalerweise nicht zeitkritisch ist. Da allerdings üblicherweise die hochfrequenten Magnetresonanzbilder nicht von der Steuervorrichtung zwischengespeichert werden können, kann das Rekonstruktionssystem sehr weiche Echtzeitanforderungen erfüllen, damit die Massendaten, insbesondere von dem Empfangsmodul, ohne Stau verlustfrei übertragen werden können.

Eine Ausführungsform sieht vor, dass das Steuersystem eine zusätzlich zur Schnittstelle des Steuersystems weitere Schnittstelle und einen zusätzlich zum Personal Computer des Steuersystems weiteren Personal Computer aufweist, wobei der weitere Personal Computer weichere Echtzeitanforderungen erfüllt als der Personal Computer, zu einem Festlegen der Messsequenz einer bildgebenden Untersuchung und einem Übertragen der Messsequenz mittels der weiteren Schnittstelle an den Personal Computer ausgebildet ist. Die weitere Schnittstelle kann beispielsweise gemäß einem Ethernet-Standard ausgebildet sein. Üblicherweise weist der weitere Personal Computer eine Anzeigeeinheit und ein Eingabegerät auf, wobei der Nutzer mittels des Eingabegeräts die Messsequenz festlegen kann. Beispielsweise ist auf einer graphischen Benutzeroberfläche der Anzeigeeinheit angezeigt, welche Messsequenz festgelegt ist. Typischerweise kann der Nutzer mittels der Anzeigeeinheit und dem Eingabegerät einen Messparameter der Messsequenz auswählen bzw. festlegen. Das Festlegen der Messsequenz ist üblicherweise nicht zeitkritisch und daher erfüllt der weitere Personal Computer weichere Echtzeitanforderungen als der Personal Computer. Es ist denkbar, dass die Echtzeitanforderungen des weiteren Personal Computers so weich sind, dass der weitere Personal Computer keine im Sinne der bildgebenden Untersuchung relevanten Echtzeitanforderungen erfüllt.

Die erfindungsgemäße Magnetresonanzanlage weist
- das Steuersystem und
- die Magnetresonanzeinrichtung auf,
- wobei die Magnetresonanzeinrichtung die Hochfrequenzsendeeinheit, die Gradientenspuleneinheit, die Peripherieeinrichtungen und die Empfangsspuleneinheit aufweist.

Die Magnetresonanzanlage weist vorzugsweise eine hohe Wiederverwertbarkeit auf, weil das Steuersystem und insbesondere die Steuervorrichtung Produktlinien-übergreifend im Wesentlichen gleich ausgestaltet sind. Vorzugsweise wird im Vergleich von einer kostengünstigeren zu einer höherpreisigen Magnetresonanzeinrichtung die Steuervorrichtung lediglich mittels des Empfangsmoduls erweitert. Beispielsweise korreliert eine Anzahl an Empfangskanälen direkt mit den Kosten der Empfangsspuleneinheit der Magnetresonanzeinrichtung.

Das Steuersystem kann gemäß den Sequenzbefehlen in der Magnetresonanzeinrichtung die bildgebende Untersuchung ausführen. Das Steuersystem ist üblicherweise in einem Technikraum angeordnet, wobei die Magnetresonanzeinrichtung insbesondere in dem Untersuchungsraum angeordnet ist. Typischerweise ist das Steuersystem, insbesondere von dem Hauptmagnetfeld der Magnetresonanzeinrichtung, abgeschirmt. Für das Steuern der Magnetresonanzeinrichtung, insbesondere für das Ansteuern der Hochfrequenzsendeeinheit und der Gradientenspuleneinheit sowie für das Erfassen der hochfrequenten Magnetresonanzsignale, sind die jeweiligen Komponenten und Einheiten vorzugsweise mit entsprechenden Kabeln verbunden, wobei die entsprechenden Kabel zwischen dem Untersuchungsraum und dem Technikraum vorzugsweise durch eine Filteranordnung hindurch geführt sind.

Im Folgenden wird die Erfindung anhand der in den Figuren dargestellten Ausführungsbeispiele näher beschrieben und erläutert.

Es zeigen:
- Fig. 1: eine Steuervorrichtung in einem ersten Ausführungsbeispiel,
- Fig. 2: eine Steuervorrichtung in einem zweiten Ausführungsbeispiel
- Fig. 3: ein System,
- Fig. 4: ein Steuersystem in einem ersten Ausführungsbeispiel,
- Fig. 5: ein Steuersystem in einem zweiten Ausführungsbeispiel und
- Fig. 6: eine Magnetresonanzanlage.

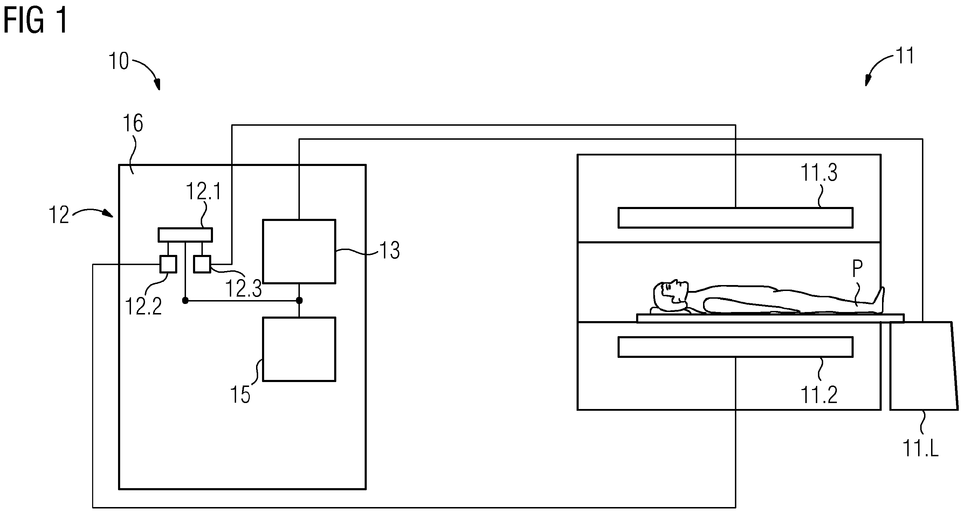

**Fig. 1** zeigt die Steuervorrichtung 10 in einem ersten Ausführungsbeispiel. Die Steuervorrichtung 10 für eine Magnetresonanzeinrichtung 11 weist ein Steuermodul 12, ein Peripheriemodul 13, einen Empfangsmodulanschluss 15 und eine Hauptplatineneinheit 16 auf. Das Steuermodul 12 weist eine zentrale Koordinationskomponente 12.1, welche zu einer Entgegennahme von gemäß einer Messsequenz berechneten Sequenzbefehlen ausgebildet ist, eine Hochfrequenzsteuerkomponente 12.2, welche zu einem Ansteuern einer Hochfrequenzsendeeinheit 11.2 der Magnetresonanzeinrichtung 11 gemäß den Sequenzbefehlen ausgebildet ist, und eine Gradientenspulensteuerkomponente 12.3, welche zu einem Ansteuern einer Gradientenspuleneinheit 11.3 der Magnetresonanzeinrichtung 11 gemäß den Sequenzbefehlen ausgebildet ist, auf. Die Hochfrequenzsteuerkomponente 12.2 ist mit der Hochfrequenzsendeeinheit 11.2 und die Gradientenspulensteuerkomponente 12.3 ist mit der Gradientenspuleneinheit 11.3 verbunden.

Das Peripheriemodul 13 ist zu einem Ansteuern von Peripherieeinrichtungen der Magnetresonanzeinrichtung 11 ausgebildet. In diesem Beispiel weisen die Peripherieeinrichtungen eine Patientenliege 11.L auf. Das Peripheriemodul 13 ist mit der Patientenliege 11.L verbunden. Ein Patient P ist auf der Patientenliege 11.L angeordnet.

Das Steuermodul 12 und das Peripheriemodul 13 erfüllen Echtzeitanforderungen. Der Empfangsmodulanschluss 15 ist ebenfalls echtzeitfähig und zu einem Anschließen eines Empfangsmoduls 17 ausgebildet, wobei in diesem Ausführungsbeispiel das Empfangsmodul 17 nicht an dem Empfangsmodulanschluss 15 angeschlossen und daher nicht in Fig. 1 abgebildet ist. Wenn in einem alternativen Ausführungsbeispiel das Empfangsmodul 17 angeschlossen ist, dann erfüllen das Steuermodul 12, das Peripheriemodul 13 und das Empfangsmodul 17 jeweils die Echtzeitanforderungen, weil der Empfangsmodulanschluss 15 ebenfalls entsprechend ausgebildet ist.

Das Steuermodul 12, insbesondere die zentrale Koordinationskomponente 12.1, das Peripheriemodul 13 und der Empfangsmodulanschluss 15 sind in die Hauptplatineneinheit 16 integriert und untereinander verbunden. Die Hauptplatineneinheit 16 weist zumindest eine Leiterplatte auf, wobei in einem anderen Ausführungsbeispiel auch mehrere Leiterplatten denkbar sind, welche untereinander insbesondere elektrisch verbunden sind.

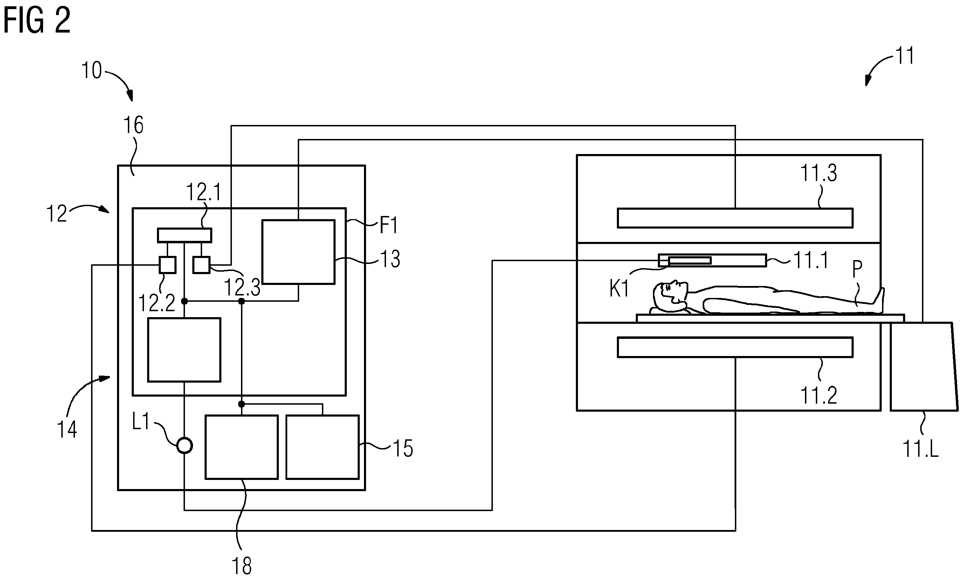

**Fig. 2** zeigt die Steuervorrichtung 10 in einem zweiten Ausführungsbeispiel. Die Steuervorrichtung 10 weist eine Zeitabstimmungskomponente 18 auf, wobei die Zeitabstimmungskomponente 18 in die Hauptplatineneinheit 16 integriert ist und zu einem Ausgeben eines Taktsignals sowie zu einem zeitlichen Abstimmen des Steuermoduls 12, des Peripheriemoduls 13 und des Empfangsmodulanschlusses 15 mittels des Taktsignals ausgebildet ist. Die Zeitabstimmungskomponente 18 ist mit dem Steuermodul 12, insbesondere der zentralen Koordinationskomponente 12.1, dem Peripheriemodul 13 und dem Empfangsmodulanschluss 15 verbunden.

Die Steuervorrichtung 10 weist einen FPGA F1 auf, wobei der FPGA F1 als eine einzige Hardware-Baueinheit ausgebildet ist. Ein logischer Teil des Steuermoduls 12 und ein logischer Teil des Peripheriemoduls 13 sind in dem FPGA F1 abgebildet, wobei alternativ auch lediglich der logische Teil des Steuermoduls 12 oder der logische Teil des Peripheriemoduls 13 in dem FPGA F1 abgebildet sein können. Ein physischer Teil des Steuermoduls 12 und des Peripheriemoduls 13 ist in Fig. 2 nicht gezeigt. Der FPGA F1 ist in die Hauptplatineneinheit 16 integriert. Der Empfangsmodulanschluss 15 ist außerhalb des FPGAs F1 in die Hauptplatineneinheit 16 integriert und mit dem FPGA F1 zu einem Übertragen von hochfrequenten Magnetresonanzsignalen und/oder des Taktsignals verbunden.

Die Steuervorrichtung 10 weist ein integriertes Empfangsmodul 14 auf. Das integrierte Empfangsmodul 14 ist zu einem Erfassen der mittels eines Empfangskanals K1 einer Empfangsspuleneinheit 11.1 der Magnetresonanzeinrichtung 11 empfangenen hochfrequenten Magnetresonanzsignale ausgebildet ist und ist mittels eines Übertragungskabels mit der Empfangsspuleneinheit 11.1, insbesondere mit dem Empfangskanal K1, verbunden. Der Empfangskanal K1 entspricht in diesem Beispiel einem physischen Spulenelement der Empfangsspuleneinheit 11.1. Typischerweise weist die Empfangsspuleneinheit 11.1 mehrere physische Spulenelemente auf. Das integrierte Empfangsmodul 14 erfüllt die Echtzeitanforderungen, ist in die Hauptplatineneinheit 16 integriert und mit der Zeitabstimmungskomponente 18 verbunden. Das integrierte Empfangsmodul 14 ist zusätzlich mit der zentralen Koordinationskomponenten 12.1 verbunden, beispielsweise für ein Erfassen der hochfrequenten Magnetresonanzsignale gemäß einem Auslese-Zeitraum.

Das integrierte Empfangsmodul 14, insbesondere ein physischer Teil des integrierten Empfangsmoduls 14, weist einen Lichtwellenleiteranschluss L1 auf, wobei der Lichtwellenleiteranschluss L1 zu einem Anschließen des Empfangskanals K1 der Empfangsspuleneinheit 11.1 der Magnetresonanzeinrichtung 11 und zu einem Übertragen der hochfrequenten Magnetresonanzsignale von dem integrierten Empfangskanal K1 der Empfangsspuleneinheit 11.1 an das integrierte Empfangsmodul 14 ausgebildet ist. In diesem Beispiel ist der Empfangskanal K1 mit dem Lichtwellenleiteranschluss L1, sprich dem physischen Teil des integrierten Empfangsmoduls 14, verbunden.

Das integrierte Empfangsmodul 14, insbesondere ein logischer Teil des integrierten Empfangsmoduls 14, ist in dem FPGA F1 abgebildet und der FPGA F1 ist zu einem Filtern der hochfrequenten Magnetresonanzsignale ausgebildet. Der physische Teil des integrierten Empfangsmoduls 14, insbesondere der Lichtwellenleiteranschluss L1, ist nicht in dem FPGA F1 abgebildet, sondern lediglich mit dem FPGA F1 elektrisch verbunden. Der Lichtwellenleiteranschluss L1 ist in die Hauptplatineneinheit 16 integriert.

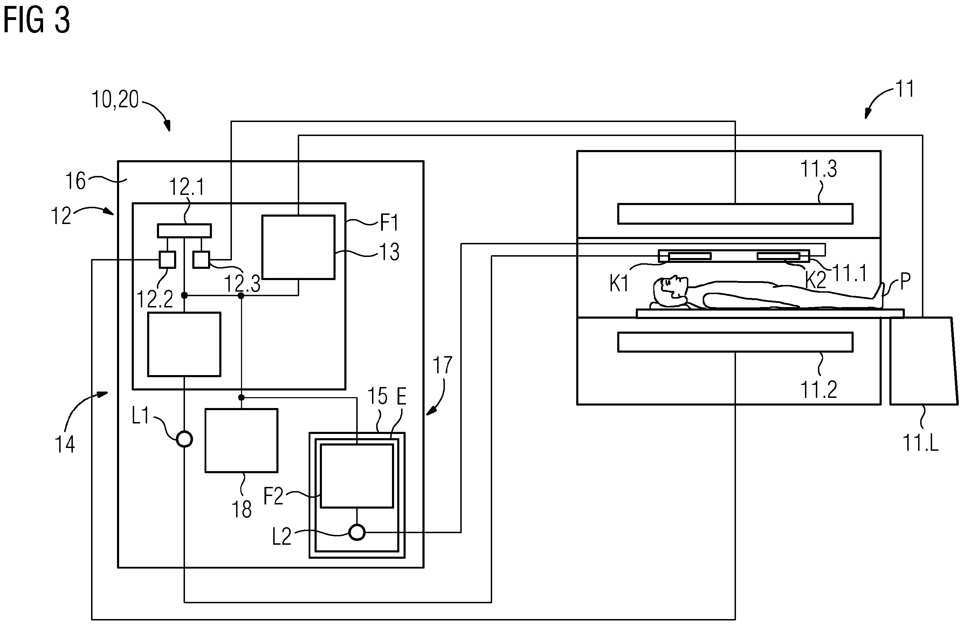

**Fig. 3** zeigt das System 20. Das System 20 weist die Steuervorrichtung 10 und das Empfangsmodul 17 auf, wobei die Empfangsspuleneinheit 11.1 der Magnetresonanzeinrichtung 11 zusätzlich zu dem Empfangskanal K1 einen weiteren Empfangskanal K2 aufweist. Der weitere Empfangskanal K2 entspricht in diesem Beispiel einem weiteren physischen Spulenelement der Empfangsspuleneinheit 11.1. In diesem Ausführungsbeispiel weist die Steuervorrichtung 10 zusätzlich das integrierte Steuermodul 14 auf.

Das Empfangsmodul 17 ist mittels des Empfangsmodulanschlusses 15 an die Hauptplatineneinheit 16 angeschlossen und zu einem Erfassen von mittels des weiteren Empfangskanals K2 der Empfangsspuleneinheit 11.1 der Magnetresonanzeinrichtung 11 empfangenen hochfrequenten Magnetresonanzsignalen ausgebildet.

Das Empfangsmodul 17 weist einen Lichtwellenleiteranschluss L2 und einen FPGA F2 auf, wobei der Lichtwellenleiteranschluss L2 zu einem Anschließen des weiteren Empfangskanals K2 der Empfangsspuleneinheit 11.1 der Magnetresonanzeinrichtung 11 ausgebildet ist und wobei der FPGA F2 des Empfangsmoduls 17 zu einem Filtern der hochfrequenten Magnetresonanzsignale ausgebildet ist. In diesem Beispiel weist das Empfangsmodul 17 eine Einsteckkarte E auf, wobei das Empfangsmodul 17 mittels der Einsteckkarte E an dem Empfangsmodulanschluss 15 angeschlossen ist. Der FPGA F2 ist in die Einsteckkarte E integriert, wobei eine Logik des Empfangsmoduls 17 in dem FPGA F2 abgebildet ist. Die Logik umfasst beispielsweise das Filtern und Vorverarbeiten der mittels des weiteren Empfangskanals K2 empfangenen hochfrequenten Magnetresonanzsignale. Ein physischer Teil des Empfangsmoduls 17, insbesondere der Lichtwellenleiteranschluss L2, ist außerhalb des FPGAs F2 in die Einsteckkarte E integriert.

Grundsätzlich wäre es denkbar, dass die Steuervorrichtung 10 zusätzlich zu dem Empfangsmodulanschluss 15 einen Erweiterungsempfangsmodulanschluss und/oder einen Erweiterungsperipheriemodulanschluss aufweist. Der Erweiterungsempfangsmodulanschluss ermöglicht vorzugsweise ein Anschließen eines Erweiterungsempfangsmoduls für weitere Empfangskanäle der Empfangsspuleneinheit 11.1. Der Erweiterungsperipheriemodulanschluss ist beispielsweise derart ausgebildet, dass mittels eines Erweiterungsperipheriemoduls eine Kapazität der Steuervorrichtung 10 bzw. des Systems 20 in Hinblick auf einen Anschluss von Peripherieeinrichtung der Magnetresonanzeinrichtungen 11 vergrößert wird.

Die nachfolgende Beschreibung beschränkt sich im Wesentlichen auf die Unterschiede zu den Ausführungsbeispielen in Fig. 1 bis Fig. 3, wobei bezüglich gleich bleibender Merkmale auf die Beschreibung der Ausführungsbeispiels in Fig. 1 bis Fig. 3 verwiesen wird. Im Wesentlichen gleich bleibende Merkmale sind grundsätzlich mit den gleichen Bezugszeichen beziffert.

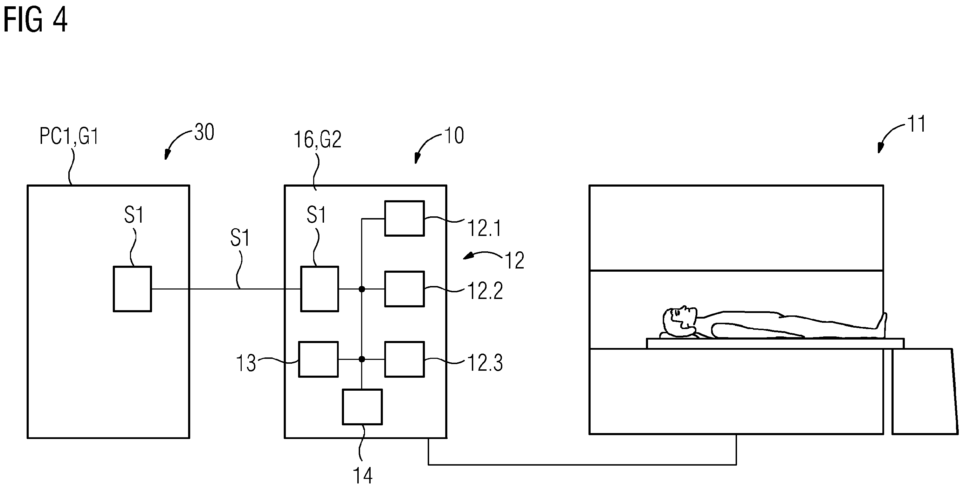

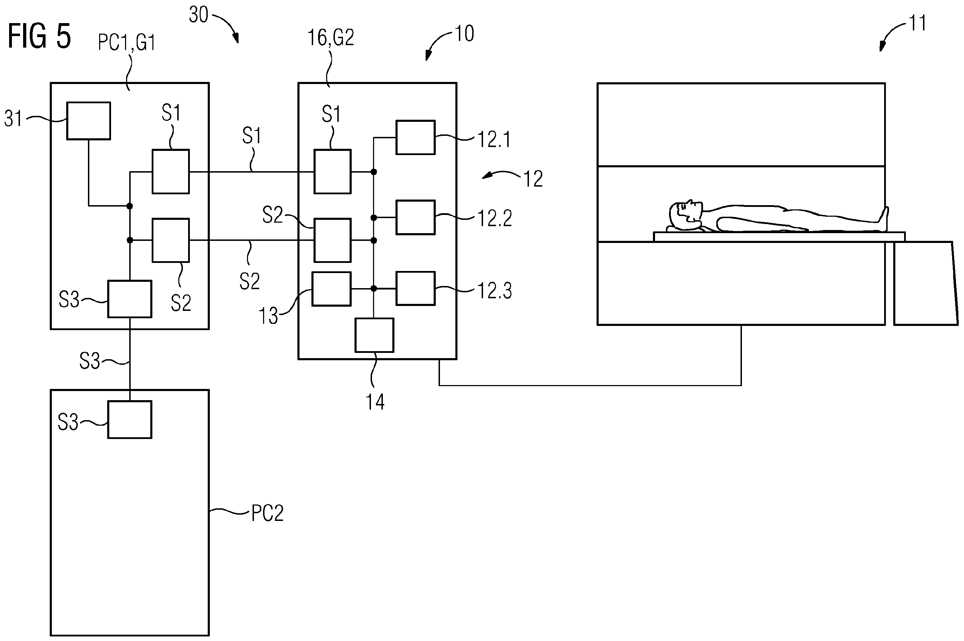

**Fig. 4** zeigt das Steuersystem 30 in einem ersten Ausführungsbeispiel. In diesem und in den in Fig. 5 bis Fig. 6 gezeigten Ausführungsbeispielen weist die Steuervorrichtung 10 das integrierte Empfangsmodul 14 auf. Alternativ oder zusätzlich könnte die Steuervorrichtung 10 mittels des Empfangsmoduls an dem Empfangsmodulanschluss erweitert sein. Aus Gründen der Übersichtlichkeit und der im Wesentlichen gleichen Funktionalität wird zwischen diesen Möglichkeiten im Folgenden nicht unterschieden.

Das Steuersystem 30 weist eine Schnittstelle S1, einen Personal Computer PC1 und die Steuervorrichtung 10 auf. Der Personal Computer PC1 erfüllt weichere Echtzeitanforderungen als das Steuermodul 12, das Peripheriemodul 13 und das integrierte Empfangsmodul 14. Beispielsweise wenn das Steuermodul 12 die harten Echtzeitanforderungen erfüllt, erfüllt der Personal Computer PC1 die weichen Echtzeitanforderungen. Der Personal Computer PC1 ist zu einem Berechnen der Sequenzbefehle gemäß der Messsequenz ausgebildet ist und weist ein Gehäuse G1 auf. Das Gehäuse G1 entspricht einem handelsüblichen Gehäuse des handelsüblichen Personal Computers PC1. Die Schnittstelle S1 ist drahtgebunden und zu einem Übertragen der Sequenzbefehle von dem Personal Computer PC1 an die zentrale Koordinationskomponente 12.1 ausgebildet. Des Weiteren ist die Schnittstelle S1 zu einem Übertragen der hochfrequenten Magnetresonanzsignale von dem Empfangsmodul 14 an den Personal Computer PC1 ausgebildet.

Die Steuervorrichtung 10 ist mittels der Schnittstelle S1 mit dem Personal Computer PC1 verbunden und außerhalb des Gehäuses G1 des Personal Computers PC1 angeordnet. Die Steuervorrichtung 10 kann beispielsweise ein Technikgehäuse G2 aufweisen, wobei die Hauptplatineneinheit 16 innerhalb des Technikgehäuses G2 eingerichtet ist. Das Technikgehäuse G2 kann insbesondere unmittelbar auf dem Gehäuse G1 des Personal Computers PC1 liegen oder alternativ etwas entfernt, aber trotzdem in räumlicher Nähe zu dem Personal Computer PC1. Vorzugsweise unterliegt das Technikgehäuse G2 nicht den räumlichen Beschränkungen des Gehäuses G1 des Personal Computers PC1. In diesem Fall ist beispielsweise eine effiziente Kühlung der Steuervorrichtung 10 möglich.

**Fig. 5** zeigt das Steuersystem 30 in einem zweiten Ausführungsbeispiel. Der Personal Computer PC1 weist ein Rekonstruktionssystem 31 auf, welches zu einer Rekonstruktion von Magnetresonanzbildern gemäß den hochfrequenten Magnetresonanzsignalen ausgebildet ist. Die hochfrequenten Magnetresonanzsignale werden vorzugsweise von der Steuervorrichtung 10, insbesondere dem integrierten Empfangsmodul 14, an das Rekonstruktionssystem 31 übertragen.

Das Steuersystem 30 weist eine Massendatenschnittstelle S2 auf, wobei die Steuervorrichtung 10 mittels der Massendatenschnittstelle S2 mit dem Personal Computer PC1 verbunden ist. Das Steuersystem 30 kann weitere Schnittstellen neben der Schnittstelle S1 und der Massendatenschnittstelle S2 zwischen dem Personal Computer PC1 und der Steuervorrichtung 10 aufweisen. Die Massendatenschnittstelle S2 ist drahtgebunden und zu einem Übertragen der hochfrequenten Magnetresonanzsignale von dem integrierten Empfangsmodul 14 an den Personal Computer PC1 ausgebildet. Die Schnittstelle S1 erfüllt im Vergleich zu der Massendatenschnittstelle S2 härtere Echtzeitanforderungen auf. In diesem Ausführungsbeispiel werden vorzugsweise die hochfrequenten Magnetresonanzsignale über die Massendatenschnittstelle S2 übertragen.

Die Schnittstelle S1 ist innerhalb des Gehäuses G1 angeordnet. In diesem Fall ist beispielsweise die Schnittstelle S1 als Einsteckkartenanschluss eines Mainboards des Personal Computers PC1 ausgebildet. Vorzugsweise ist der Einsteckkartenanschluss für das Anschließen der Schnittstelle S1, insbesondere eines Kabels der Schnittstelle S1, ausgebildet. Das Kabel kann beispielsweise dem PCIe-Standard entsprechen und den Einsteckkartenanschluss verlängern. Im Wesentlichen wird der Einsteckkartenanschluss des Mainboards aus dem Gehäuse G1 hinaus verlängert.

Das Steuersystem 30 weist eine zusätzlich zur Schnittstelle S1 des Steuersystems 30 weitere Schnittstelle S3 und einen zusätzlich zum Personal Computer PC1 des Steuersystems 30 weiteren Personal Computer PC2 auf. Der weitere Personal Computer PC2 erfüllt weichere Echtzeitanforderungen als der Personal Computer PC1, ist zu einem Festlegen der Messsequenz einer bildgebenden Untersuchung und einem Übertragen der Messsequenz mittels der weiteren Schnittstelle S3 an den Personal Computer PC1 ausgebildet.

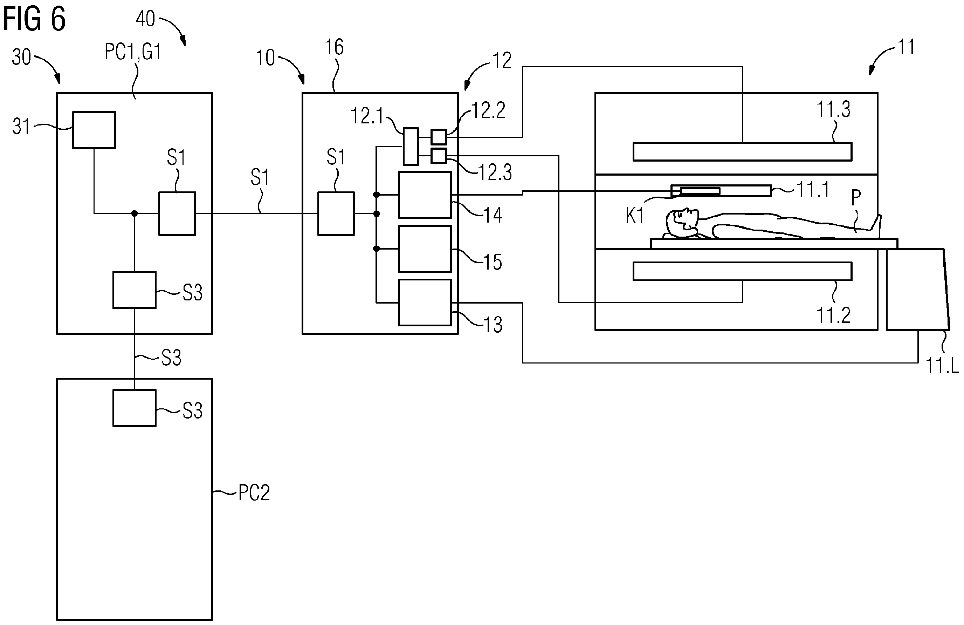

**Fig. 6** zeigt die Magnetresonanzanlage 40. Die Magnetresonanzanlage 40 weist das Steuersystem 30 und die Magnetresonanzeinrichtung 11 auf, wobei die Magnetresonanzeinrichtung 11 die Hochfrequenzsendeeinheit 11.2, die Gradientenspuleneinheit 11.3, die Peripherieeinrichtungen und die Empfangsspuleneinheit 11.1 aufweist. Die Peripherieeinrichtungen weisen die Patientenliege 11.L auf.

Die Empfangsspuleneinheit 11.1 ist in einem tunnelförmigen Hohlraum der Magnetresonanzeinrichtung 11 angeordnet. Beispielsweise ist die Empfangsspuleneinheit 11.1 als Oberflächenspule ausgebildet, welche auf den Patienten P gelegt oder über dem Patienten P befestigt werden kann. Der tunnelförmige Hohlraum ist von einer Abdeckung der Magnetresonanzeinrichtung 11 umschlossen. Von der Abdeckung der Magnetresonanzeinrichtung 11 werden die Hochfrequenzsendeeinheit 11.2 und die Gradientenspuleneinheit 11.3 verdeckt. Eine Hauptmagnetfeldeinheit der Magnetresonanzeinrichtung 11 ist ebenfalls innerhalb der Abdeckung angeordnet. In diesem Beispiel weist die Empfangsspuleneinheit 11.1 lediglich den Empfangskanal K1 auf, wobei üblicherweise heutzutage eine Vielzahl an Empfangskanälen in einer Empfangsspuleneinheit verbaut sind.

Mittels der Magnetresonanzanlage 40 kann der Nutzer beispielsweise eine bildgebende Untersuchung, insbesondere eine Magnetresonanztomographie-Untersuchung, steuern. Ein übliches Vorgehen könnte wie folgt aussehen: Der Nutzer legt an dem weiteren Personal Computer PC2, der beispielsweise in einem Benutzerraum angeordnet ist, die Messsequenz auf einer graphischen Benutzeroberfläche fest. Die Messsequenz wird mittels der weiteren Schnittstelle S3 auf den Personal Computer PC1 übertragen. Der Personal Computer PC1 berechnet die Sequenzbefehle gemäß der Messsequenz und überträgt die Sequenzbefehle mittels der Schnittstelle S1 an die Steuervorrichtung 10. Das Steuermodul 12, insbesondere die zentrale Koordinationskomponente 12.1, nimmt die Sequenzbefehle entgegen und koordiniert die Weitergabe der Sequenzbefehle an die Hochfrequenzsteuerkomponente 12.2 und an die Gradientenspulensteuerkomponente 12.3. Die Hochfrequenzsteuerkomponente 12.2 steuert die Hochfrequenzsendeeinheit 11.2 der Magnetresonanzeinrichtung 11 gemäß den Sequenzbefehlen derart an, dass Hochfrequenzpulse in dem tunnelförmigen Hohlraum der Magnetresonanzeinrichtung 11 ausgesendet werden. Die Gradientenspulensteuerkomponente 12.3 steuert die Gradientenspuleneinheit 11.3 der Magnetresonanzeinrichtung 11 gemäß den Sequenzbefehlen derart an, dass Gradientenfelder in dem tunnelförmigen Hohlraum der Magnetresonanzeinrichtung 11 ein Hauptmagnetfeld der Hauptmagnetfeldeinheit überlagern. Üblicherweise kann die Empfangsspuleneinheit 11.1, insbesondere der Empfangskanal K1, die hochfrequenten Magnetresonanzsignale empfangen und in diesem Beispiel an das integrierte Empfangsmodul 14 übertragen. Nach einem Vorverarbeiten und Filtern der hochfrequenten Magnetresonanzsignale werden diese mittels der Schnittstelle S1 an den Personal Computer PC1 übertragen. Üblicherweise weist der Personal Computer PC1 das Rekonstruktionssystem 31 auf, um gemäß den hochfrequenten Magnetresonanzsignalen die Magnetresonanzbilder zu rekonstruieren. Vorzugsweise kann der Nutzer die Magnetresonanzbilder auf der graphischen Benutzeroberfläche einsehen, nachdem die Magnetresonanzbilder mittels der weiteren Schnittstelle S3 auf den weiteren Personal Computer PC2 übertragen sind.

Obwohl die Erfindung im Detail durch die bevorzugten Ausführungsbeispiele näher illustriert und beschrieben wurde, so ist die Erfindung dennoch nicht durch die offenbarten Beispiele eingeschränkt und andere Variationen können vom Fachmann hieraus abgeleitet werden, ohne den Schutzumfang der Erfindung zu verlassen.

## Patentansprüche

1. Steuervorrichtung (10) für eine Magnetresonanzeinrichtung (11), aufweisend
- ein Steuermodul (12),
- ein Peripheriemodul (13),
- einen Empfangsmodulanschluss (15) und
- eine Hauptplatineneinheit (16),
wobei das Steuermodul (12)
- eine zentrale Koordinationskomponente (12.1), welche zu einer Entgegennahme von gemäß einer Messsequenz berechneten Sequenzbefehlen ausgebildet ist,
- eine Hochfrequenzsteuerkomponente (12.2), welche zu einem Ansteuern einer Hochfrequenzsendeeinheit (11.2) der Magnetresonanzeinrichtung (11) gemäß den Sequenzbefehlen ausgebildet ist, und
- eine Gradientenspulensteuerkomponente (12.3), welche zu einem Ansteuern einer Gradientenspuleneinheit (11.3) der Magnetresonanzeinrichtung (11) gemäß den Sequenzbefehlen ausgebildet ist, aufweist,
- wobei das Peripheriemodul (13) zu einem Ansteuern von Peripherieeinrichtungen der Magnetresonanzeinrichtung (11) ausgebildet ist,
- wobei das Steuermodul (12) und das Peripheriemodul (13) Echtzeitanforderungen erfüllen,
- wobei der Empfangsmodulanschluss (15) zu einem Anschließen eines Empfangsmoduls (17) ausgebildet ist,
**dadurch gekennzeichnet,**
- **dass** das Steuermodul (12), das Peripheriemodul (13) und der Empfangsmodulanschluss (15) in die Hauptplatineneinheit (16) integriert sind.

2. Steuervorrichtung (10) nach Anspruch 1, **dadurch gekennzeichnet, dass** die Steuervorrichtung (10) eine Zeitabstimmungskomponente (18) aufweist und dass die Zeitabstimmungskomponente (18) in die Hauptplatineneinheit (16) integriert ist und zu einem Ausgeben eines Taktsignals sowie zu einem zeitlichen Abstimmen des Steuermoduls (12), des Peripheriemoduls (13) und des Empfangsmodulanschlusses (15) mittels des Taktsignals ausgebildet ist.

3. Steuervorrichtung (10) nach einem der vorhergehenden Ansprüche, **dadurch gekennzeichnet, dass** die Steuervorrichtung (10) einen FPGA (F1) aufweist, wobei der FPGA (F1) als eine einzige Hardware-Baueinheit ausgebildet ist, und dass das Steuermodul (12) und/oder das Peripheriemodul (13) in dem FPGA (F1) abgebildet sind.

4. Steuervorrichtung (10) nach einem der vorhergehenden Ansprüche, **dadurch gekennzeichnet, dass** die Steuervorrichtung (10) ein integriertes Empfangsmodul (14) aufweist und dass das integrierte Empfangsmodul (14) zu einem Erfassen von mittels eines Empfangskanals (K1) einer Empfangsspuleneinheit (11.1) der Magnetresonanzeinrichtung (11) empfangenen hochfrequenten Magnetresonanzsignalen ausgebildet ist, die Echtzeitanforderungen erfüllt und in die Hauptplatineneinheit (16) integriert ist.

5. Steuervorrichtung (10) nach den Ansprüchen 3 bis 4, **dadurch gekennzeichnet, dass** das integrierte Empfangsmodul (14) in dem FPGA (F1) abgebildet ist und der FPGA (F1) zu einem Filtern der hochfrequenten Magnetresonanzsignale ausgebildet ist.

6. Steuervorrichtung (10) nach einem der Ansprüche 4 bis 5, **dadurch gekennzeichnet, dass** das integrierte Empfangsmodul (14) einen Lichtwellenleiteranschluss (L1) aufweist, wobei der Lichtwellenleiteranschluss (L1) zu einem Anschließen des Empfangskanals (K1) der Empfangsspuleneinheit (11.1) der Magnetresonanzeinrichtung (11) und zu einem Übertragen der hochfrequenten Magnetresonanzsignale von dem Empfangskanal (K1) der Empfangsspuleneinheit (11.1) an das integrierte Empfangsmodul (14) ausgebildet ist.

7. System (20), aufweisend
- die Steuervorrichtung (10) nach einem der vorhergehenden Ansprüche und
- das Empfangsmodul (17),
- wobei eine Empfangsspuleneinheit (11.1) der Magnetresonanzeinrichtung (11) einen Empfangskanal (K1) aufweist und
- wobei das Empfangsmodul (17) mittels des Empfangsmodulanschlusses (15) an die Hauptplatineneinheit (16) angeschlossen ist und zu einem Erfassen von mittels des Empfangskanals (K1) der Empfangsspuleneinheit (11.1) der Magnetresonanzeinrichtung (11) empfangenen hochfrequenten Magnetresonanzsignalen ausgebildet ist.

8. System (20) nach Anspruch 7, wobei das Empfangsmodul (17) einen Lichtwellenleiteranschluss (L2) und einen FPGA (F2) aufweist, wobei der Lichtwellenleiteranschluss (L2) zu einem Anschließen des Empfangskanals (K1) der Empfangsspuleneinheit (11.1) der Magnetresonanzeinrichtung (11) ausgebildet ist und wobei der FPGA (F2) des Empfangsmoduls (17) zu einem Filtern der hochfrequenten Magnetresonanzsignale ausgebildet ist.

9. System (20) nach einem der Ansprüche 7 bis 8,
- wobei die Steuervorrichtung (10) nach einem der Ansprüche 4 bis 6 ausgebildet ist,
- wobei die Empfangsspuleneinheit (11.1) der Magnetresonanzeinrichtung (11) zusätzlich zu dem Empfangskanal (K1) einen weiteren Empfangskanal (K2) aufweist,
- wobei das Empfangsmodul (17) zu einem Erfassen von mittels des weiteren Empfangskanals (K2) der Empfangsspuleneinheit (11.1) der Magnetresonanzeinrichtung (11) empfangenen hochfrequenten Magnetresonanzsignalen ausgebildet ist.

10. Steuersystem (30), aufweisend
- eine Schnittstelle (S1),
- einen Personal Computer (PC1) und
- die Steuervorrichtung (10), welche nach einem der Ansprüche 1 bis 6 ausgebildet ist,
- wobei der Personal Computer (PC1) weichere Echtzeitanforderungen erfüllt als das Steuermodul (12) und das Peripheriemodul (13),
- wobei der Personal Computer (PC1) zu einem Berechnen der Sequenzbefehle gemäß der Messsequenz ausgebildet ist und ein Gehäuse (G1) aufweist,
- wobei die Schnittstelle (S1) drahtgebunden und zu einem Übertragen der Sequenzbefehle von dem Personal Computer (PC1) an die zentrale Koordinationskomponente (12.1) ausgebildet ist und
- wobei die Steuervorrichtung (10) mittels der Schnittstelle (S1) mit dem Personal Computer (PC1) verbunden ist und außerhalb des Gehäuses (G1) des Personal Computers (PC1) angeordnet ist.

11. Steuersystem (30) nach Anspruch 10, wobei das Steuersystem (30) eine Massendatenschnittstelle (S2) aufweist, wobei die Steuervorrichtung (10) mittels der Massendatenschnittstelle (S2) mit dem Personal Computer (PC1) verbunden ist, wobei die Massendatenschnittstelle (S2) drahtgebunden und zu einem Übertragen der hochfrequenten Magnetresonanzsignale von der Steuervorrichtung (10) an den Personal Computer (PC1) ausgebildet ist und wobei die Schnittstelle (S1) im Vergleich zu der Massendatenschnittstelle (S2) härtere Echtzeitanforderungen erfüllt.

12. Steuersystem (30) nach einem der Ansprüche 10 bis 11, wobei der Personal Computer (PC1) ein Rekonstruktionssystem (31) aufweist, welches zu einer Rekonstruktion von Magnetresonanzbildern gemäß den hochfrequenten Magnetresonanzsignalen ausgebildet ist.

13. Steuersystem (30) nach einem der Ansprüche 10 bis 12, wobei die Schnittstelle (S1) innerhalb des Gehäuses (G1) angeordnet ist.

14. Steuersystem (30) nach einem der Ansprüche 10 bis 13, wobei das Steuersystem (30) eine zusätzlich zur Schnittstelle (S1) des Steuersystems (30) weitere Schnittstelle (S3) und einen zusätzlich zum Personal Computer (PC1) des Steuersystems (30) weiteren Personal Computer (PC2) aufweist, wobei der weitere Personal Computer (PC2) weichere Echtzeitanforderungen erfüllt als der Personal Computer (PC1), zu einem Festlegen der Messsequenz einer bildgebenden Untersuchung und einem Übertragen der Messsequenz mittels der weiteren Schnittstelle (S3) an den Personal Computer (PC1) ausgebildet ist.

15. Magnetresonanzanlage (40), aufweisend
- das Steuersystem (30), welches nach einem der Ansprüche 10 bis 14 ausgebildet ist, und
- die Magnetresonanzeinrichtung (11),
- wobei die Magnetresonanzeinrichtung (11) die Hochfrequenzsendeeinheit (11.2), die Gradientenspuleneinheit (11.3), die Peripherieeinrichtungen und die Empfangsspuleneinheit (11.1) aufweist.
